# EUROPEAN PATENT APPLICATION

(11) **EP 2 597 650 A1**
(43) Date of publication of application: **29.05.2013**
(21) Application number: 11306538.7
(22) Date of filing: 22.11.2011
(51) Int. Cl.: G11C 17/02

(54) **Data storage device, device and method for writing and reading the data storage device, use of a weaving unit**

(71) Applicant: Thomson Licensing, 92130 Issy-les-Moulineaux (FR)
(72) Inventor: Blawat, Meinolf, 30659 Hannover (DE); Schweidler, Siegfried, 30989 Gehrden (DE); Gaedke, Klaus, 30659 Hannover (DE)
(74) Representative: Thies, Stephan

(57) **Abstract**

Data storage device 2 for long term data storage, device 14 for generating the data storage device 2, device 16 for reading the data storage device 2, method for storing digital data, method for reading the data storage device 2 and use of a weaving unit 12. The data storage device 2 comprises a woven pattern consisting of a plurality of horizontal fibres 4 and a plurality of vertical fibres 6 that form a plurality of intersections 8. Each intersection 8 represents a binary data cell and data is coded in the binary data cell by the way the horizontal and vertical fibre 4, 6 is woven at the respective intersection 8.

## Description

### FIELD OF THE INVENTION

The invention relates to a data storage device for long term data storage, a device for generating the data storage, a device for reading the data storage device, a method for storing digital data in the data storage device and the use of a weaving unit for manufacture of the data storage device.

### BACKGROUND

Long term conservation or storage of digital data is one of the challenges in the digital data ages. Especially for film studios, long term data storage is off significant interest since the produced digital media data represents all the assets of the film studios. During the pre- and post-production phase, the gathered and generated media data is typically stored on several hard disks and digital tapes. However, hard disks have a typical life span of about five years and storing media data on hard disks only is no sufficient way to archive these digital data for long periods of time. Digital tapes are no reliable long term data storage, too. After one or latest two decades, archived data can be retrieved with a steadily increasing error rate only. Further, a typical data tape storage demands for expensive warehousing conditions during the whole ongoing archiving time. Nevertheless, even if the digital tapes have been stored cool, dry, dark and in absence of magnetic fields, they will show significant error rates after at least a few decades. In today's mass storage technology, there is no data storage medium available which allows directly archiving digital data at reasonable costs and with sufficient long term stability. All commonly known mass storage technologies, further examples are DVD- and Blu-ray-disks, do not offer the needed data retention time which should be in the order of several decades or even hundred years and more. In order to overcome this technical drawback, one option is to migrate data to newer media in regular time intervals. However, data migration is a serious source for causing errors corrupting the archiving reliability. Further, data migration leads to high maintenance costs since the stored data has to be copied to a new media if the expected life span of the storage medium is reaching its end.

Especially in the film industry, a huge amount of digital data is being produced every year. For example, only the digital master of a movie that is produced in the 4K digital cinema format leads to about 12.5 TByte of digital data according to a very conservative estimation. The accumulated digital data of a movie production may easily sum up to 2 PByte. The yearly production of cinema film in the US, EU and Japan is slightly increasing since the beginning of this century and is about 800 movies per year for the EU, about 700 hundred movies per year for the US and about 350 movies per year for Japan in 2005. For example, each of the nine major film studios of the US film industry produces about 950 TByte of digital master movie data every year. Accordingly, there is a significant demand for highly reliable, long term stable and cost effective mass storage media.

### SUMMARY

It is an object of the invention to provide a data storage device, a device for generating the data storage device, a device for reading the data storage device, a method for storing digital data and a method for reading the storage device, wherein the storage device offers long term data stability at reasonable costs.

According to an aspect of the invention, a data storage device for long term data storage is provided. The storage device comprises a woven pattern consisting of a plurality of horizontal fibres and a plurality of vertical fibres that form a plurality of intersections. Each intersection represents a binary data cell and data is coded in the binary data cell by the way the horizontal and vertical fibre is woven at the respective intersection.

Advantageously, the data storage device that is based on woven fibres or filaments is cost effective because fibres that may be taken off the shelf may be utilised. The data storage device is hard wearing and resistive to a variety of environmental influences such as humidity and temperature. Advantageously, no expensive cooling is necessary for warehousing the data storage device. Further, there are no special demands on humidity control and no extraordinary fire protection measures are necessary. This is especially advantageous with respect to maintenance costs. The technology for weaving fibres is well known and the complexity of the data storage device is comparably low. This is advantageous for long term data storage, because the machinery for manufacturing, writing and/or reading this data storage device is very likely to be available in future, too.

According to an aspect of the invention, the horizontal and vertical fibres of the woven pattern cross each other at the intersections like a weft and a warp cross in a plane weave. Binary data is coded by the sequence of the horizontal and vertical fibre at the intersections. For example, if the vertical fibre passes over the horizontal fibre, a logical "1" is coded in the respective binary data cell. Accordingly, if a horizontal fibre is passing over a vertical fibre, a logical "0" is coded in the respective binary data cell. Advantageously, this type of data coding may be achieved by single filament control, which is available in today's weaving machines or looms. The warps of a woven pattern may be controlled individually, for example all warps corresponding to a logical "1" may be lifted up and all warps corresponding to a logical "0" may be pulled down, and binary data is encoded in the respective row in the woven pattern by shooting the weft across the warps.

According to an advantageous embodiment of the invention, the fibres may be synthetic fibres. Preferably, polymer fibres or filaments may be applied. According to another advantageous embodiment, the diameter of the fibres is smaller than 100 µm, preferably smaller than 10 µm and further preferably smaller than 5 µm. A preferable fibre diameter is for example 3 µm. A reduction of the fibre diameter will increase the data storage capacity of the data storage device. Thin fibres are advantageous because information that may be stored per square unit of the woven pattern squarely increases with a linearly decreasing diameter of the fibre. In practice, a trade-off between the mechanical stability of the fibre and a high data density has to be found.

According to another aspect of the invention, the data of the data storage device is coded according to a predetermined coding scheme. For example, a deterministic random coding may be applied. Due to this, the data storage device will be less error prone and its mechanical stability will increase. This is due to the specific structure of the data storage device. In a conventional data storage device like a hard disks or a DVD, a sequence of identical bits will not affect the mechanical stability of the storage medium. However, for a woven data storage device, there may be a stability problem if a high number of identical bits is stored in the same row of the woven pattern. For example, if a high number of subsequent binary data cells, i. e. the intersections between the horizontal and vertical fibres, comprises a logical "1", at all intersections, the vertical fibre will pass over the respective vertical fibre. This may affect the mechanical stability of the data storage device at least in this specific area thereof. By application of a deterministic random coding, bit information is distributed over a larger area of the data storage device. Advantageously, an agglomeration of identical bits may be avoided.

Data security of the data storage device may be improved, if an error correction code is applied during transformation of the digital data into a map of bits for the woven pattern. This error correction code is preferably suitable for correction of burst errors which may occur if the woven data storage device is mechanically damaged in a limited area.

According to an aspect of the invention, the mechanical stability of the data storage device may be enhanced by coating at least one surface of the woven pattern. Preferably, both surfaces of the woven pattern are coated or laminated. According to an embodiment of the invention, the data storage device may be impregnated, for example by help of a synthetic resin.

According to another aspect of the invention, a device for generating a data storage device according to a single or a plurality of the above-mentioned aspects of the invention is provided. The device comprises a converter that is configured to receive digital data and to convert the digital data into a binary code for the woven pattern. Further, the device comprises a weaving unit (for example a conventional loom) that is configured to weave the data storage device according to the binary code. If a prior art loom shall be applied for weaving the data storage device according to aspects of the invention, a suitable control unit for controlling the loom has to be included in the device for generating the data storage device. This control unit may be implemented by hardware and/or software. The weaving unit is configured to weave the data storage device such that each bit of the binary code is translated into a certain type of weave between the horizontal and vertical fibre in the binary data cell at the respective intersection of the woven pattern.

A converter for encoding the digital data by application of a predetermined coding scheme, preferably by application of a deterministic random coding scheme, may be included in the device for generating the data storage. Further, the converter may be configured to convert the encoded digital data into the binary code for the woven pattern.

According to another aspect of the invention, a device for reading a data storage device according to a single or a plurality of aspects of the invention is provided. The device for reading comprises an optical and/or mechanical sensor or scanner that is configured to determine a weave type of the horizontal and vertical fibre at the respective intersection of the woven pattern. By way of an example only, the optical scanner may be a camera. By capturing certain areas or rows of the woven pattern and by subsequent image recognition, the type of weave between the horizontal and vertical fibre may be determined.

According to an aspect of the invention, a method for storing digital data in a data storage device according to aspects of the invention is provided. Digital data is received and converted into a binary code for the woven pattern. Further, the data storage device is woven according to said pattern wherein each intersection of the woven pattern represents a binary data cell and data is coded in the data cell by the way the horizontal and vertical fibre is woven at the respective intersection.

According to another aspect of the invention, a method for reading a data storage device according to aspects of the invention is provided. The woven pattern is inspected optically and/or mechanically. This inspection provides a basis for determination of a type of weave between the horizontal and vertical fibre at the respective intersections of the woven pattern.

The fibres are preferably synthetic fibres as used for clothing or technical fabrics. Such fibres have reliable quality and are off-the-self-products. Glass fibres have the advantage of being sufficiently flexible and, at the same time, having a high melting point thus being stable against temperature changes. Carbon fibres are flexible, lightweight and are about to become mass products, thus they are also readily available products.

Further, according to an aspect of the invention, the use of a weaving unit for manufacture of data storage device according to aspects of the invention is provided.

Same or similar advantages, which have been already mentioned with respect to the data storage device, apply to the device for generating the data storage device, the device for reading the data storage device, the method for storing digital data in the data storage device, the method for reading the data storage device and to the use of the weaving unit in a same or a similar way. Accordingly these advantages are not repeatedly mentioned.

### BRIEF DESCRIPTION OF FIGURES

Further aspects of the invention will ensue from the following description of example embodiments with reference to the accompanying drawings, wherein
FIG. 1 is a simplified data storage device, according to an embodiment of the invention,
FIG. 2a is the simplified data storage device of FIG. 1, wherein the binary coding scheme is illustrated,
FIG. 2b is a simplified detailed view to two different types of intersections representing a logical "1" and a logical "0",
FIG. 3 is a simplified device for generating a data storage, according to an embodiment of the invention and
FIG. 4 is a simplified device for reading a data storage, according to another embodiment of the invention.

### DETAILED DESCRIPTION OF EXAMPLE EMBODIMENTS

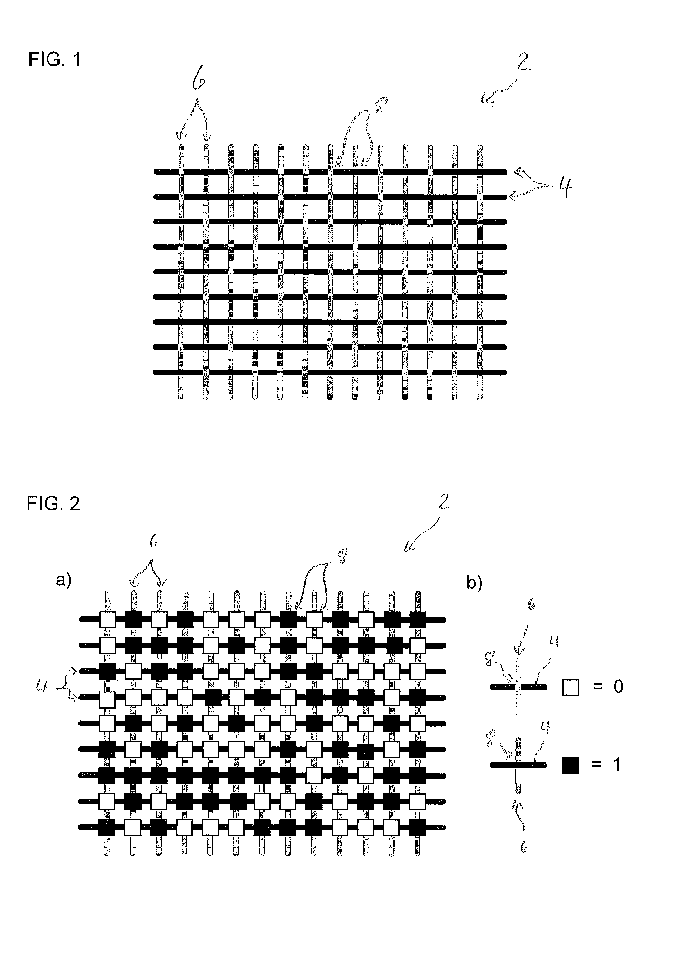

FIG. 1 is a simplified data storage device 2 comprising a woven pattern consisting of a plurality of horizontal fibres 4 and a plurality of vertical fibres 6. The horizontal and vertical fibres 4, 6 form a plurality of intersections 8. Each intersection 8 represents a binary data cell of the data storage device 2. According to the embodiment in FIG. 1, data is coded in the binary data cells, i. e. at the intersections 8 by help of the sequence of the horizontal and vertical fibres 4, 6, respectively. When comparing the data storage device 2 to a plane weave, the horizontal fibre 4 represents the weft and the vertical fibre 6 represents the warp. However, the woven structure of data storage device 2 is no plane weave. The woven pattern comprises binary data that is coded in the binary data cells formed by the intersections 8 between the horizontal and vertical fibres 4, 6.

Coding of data in the data storage device 2 will be explained by making reference to FIGs. 2a and 2b. According to the embodiment, a binary data cell represents a logical "1" if, at the respective intersection 8 between the horizontal fibre 4 and the vertical fibre 6, the horizontal fibre 4 crosses over the vertical fibre 6 (see lower intersection 8 in FIG. 2b). Accordingly, if a horizontal fibre 4 crosses over the vertical fibre 6, a logical "0" is coded in the respective data cell (see upper intersection 8 in FIG. 2b). In FIG. 2a, a logical "1" is indicated by a dark square while a logical "0" is indicated by a light square.

The storage capacity per square unit of the data storage device 2 increases squarely with linearly decreasing fibre diameter. This will be outlined in the following table:

| fibre diameter | 1 m² of fabric can store | 9 Tbyte needs |
|---|---|---|
| 100 µm | ~12 MByte | |
| 10 µm | ~1.15 GByte | 8010 m² = 89.5 m x 89.5 m |
| 3 µm | ~12.9 Gbyte | 715 m² = 26.7 m x 26.7 m |

A preferable fibre diameter is about 3 µm. By help of such a fibre or filament, reasonable 13 GByte per m² of fabric (i. e. m² surface of the data storage device 2) may be stored. This corresponds to about 480 m fabric of 1,50 m width. The fibre diameter is always a trade-off between a storage density and the mechanical stability of the fibre that is necessary for the weaving process.

According to the embodiment in FIGs. 1 and 2, binary data is coded in the data storage device 2 by applying a pure pulse modulation code. The data density may be increased by applying a suitable encoder, e. g. a JPEG 2000 encoder. This is advantageous for storage of video information. Typical lossless video encoders have a compression rate of about 1.5 to 2. However, encoders with a compression rate of up to 6 cause nearly no recognisable artefacts. Accordingly, the storage capacity per square unit of the data storage device 2 (see the above-mentioned table) may be further increased for long term storage of video data. However, it is advantageous if a suitable error correction code is applied. This error correction code has to be robust with respect to burst errors. Such a burst error may occur if the woven pattern is damaged in a limited area, e. g. due to careless handling. The error correction code will slightly decrease the compression rate.

Data security of the data storage device 2 may be increased if at least one surface of the woven pattern is coated or laminated by a suitable coating. According to another embodiment, the data storage device 2 may be impregnated i. e. by help of a synthetic resin. Polymer fibres or filaments are suitable for manufacture of the data storage device 2. If the woven pattern is additionally coated or impregnated, the data storage device 2 will be hard-wearing. It may resist acids and other chemicals, vapour and high humidity. The warehousing requirements for the data storage device 2 according to this embodiment of the invention are relatively low. No expensive cooling is necessary and there are no special demands on humidity control. This will result in very low overall costs for the data storage device 2.

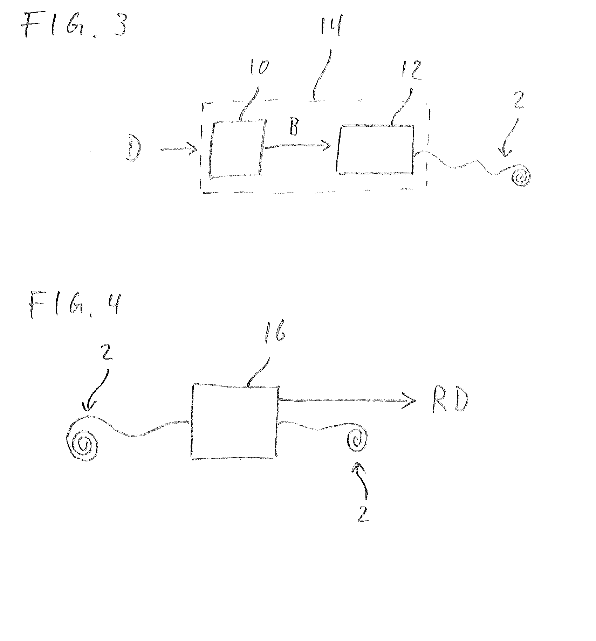

FIG. 3 is a simplified device 14 for generating a data storage device 2, according to an embodiment of the invention. The device 14 for generating the data storage device 2 comprises a converter 10 receiving digital data D. The converter 10 is configured to convert the digital data D into a binary code B. This binary code B and further optional control signals will be coupled to a weaving unit 12. The weaving unit 12 may be a special waving unit 12 which is designed for production of the data storage devices 2 upon reception of the binary data code B. However, a prior art weaving unit 12 or loom which may be taken off the shelf may be configured for production of the data storage device 2, according to aspects of the invention. The weaving unit 12 is configured in that every single vertical filament 6 may be controlled individually. The horizontal fibre 4 which is shot across the vertical fibres 6 during weaving of the data storage device 2 passes over or under the respective vertical fibres 6 according to the binary data code B. By subsequently weaving the data storage device 2 row per row, the binary data B may be coded in the woven pattern.

FIG. 4 is a simplified device 16 for reading a data storage device 2, according to an embodiment of the invention. The reading device 16 comprises an optical and/or mechanical sensor or scanner that is configured to determine a weave type between the horizontal and vertical fibre 4, 6 at the respective intersections 8. According to an embodiment, an optical scanning device e. g. a digital camera may be applied for analyzing the weave type between the horizontal and vertical fibre 4, 6. According to another embodiment, the detection of the weave type may be simplified by using different colours for the horizontal and vertical fibres 4, 6. By inspection of the intersection 8 (see FIG. 2a and 2b) the reading device 16 may decode the binary data of the respective binary data cells. In other words, the reading unit 16 may determine if the horizontal fibre 4 crosses the vertical fibre 6 (binary data "1") or if the horizontal fibre 4 crosses under the vertical fibre 6 (binary data "0"). The reading device 16 is further configured to forward decoded data RD to further units which may process the respective data.

## Claims

1. A data storage device (2) for long term data storage, comprising a woven pattern consisting of a plurality of horizontal fibres (4) and a plurality of vertical fibres (6) that form a plurality of intersections (8), wherein each intersection (8) represents a binary data cell and data is coded in the binary data cell by the way the horizontal and vertical fibre (4, 6) is woven at the respective intersection (8).

2. The data storage device (2) according to claim 1, wherein the horizontal and vertical fibres (4, 6) of the woven pattern cross each other at the intersections (8) like in plain weave a weft crosses a warp and binary data is coded by the sequence of the horizontal and vertical fibre (4, 6) at the intersection (8).

3. The data storage device (2) according to claim 1 or 2, wherein the fibres (4, 6) are synthetic fibres, preferably polymer fibres.

4. The data storage device (2) according to one of the preceding claims, wherein a diameter of the fibres (4, 6) is smaller than 100µm, preferably smaller than 10µm and further preferably smaller than 5 µm.

5. The data storage device (2) according to one of the preceding claims, wherein data in the data storage device (2) is coded according to a predetermined coding scheme.

6. The data storage device (2) according to one of the preceding claims, wherein at least one surface of the woven pattern is laminated.

7. A device (14) for generating a data storage device (2) according to one of the preceding claims, comprising:
a) a converter (10) that is configured to receive digital data (D) and to convert the digital data (D) into a binary code (B) for the woven pattern and
b) a weaving unit (12) that is configured to weave the data storage device (2) according to the binary code (B), wherein each bit of the binary code (B) is translated into a certain type of weave between the horizontal and vertical fibre (4, 6) in the binary data cell and at the respective intersection (8) of the woven pattern.

8. The device (14) according to claim 7, wherein the converter (10) is further configured to encode the digital data (D) by applying a predetermined coding scheme, preferably a deterministic random coding scheme, and to convert the encoded digital data into a binary code (B) for the woven pattern.

9. A device (16) for reading a data storage device (2) according to one of claims 1 to 6, comprising an optical and/or mechanical sensor or scanner that is configured to determine a wave type between the horizontal and vertical fibre (4, 6) at a respective intersection (8) in the woven pattern.

10. A method for storing digital data in a long term data storage device (2) according to one of claims 1 to 6, the method comprising the steps of:
a) receiving digital data (D) and converting the digital data (D) into a binary code (B) for the woven pattern and
b) weaving the data storage device (2) according to the woven pattern, wherein each intersection (8) of the woven pattern represents a binary data cell and data is encoded in the data cell by the way the horizontal and vertical fibre (4, 6) is woven at the respective intersection (8) during weaving of the data storage device (2).

11. A method for reading a data storage device (2) according to one of claims 1 to 6, the method comprising the steps of: optically and/or mechanically sensing or scanning the woven pattern and determining a type of weave between the horizontal and vertical fibre (4, 6) at a respective intersection (8) of the woven pattern.

12. Device or method of one of the preceding claims, wherein the fibres (4, 6) are one of synthetic fibre, glass fibre, and carbon fibre.

13. Use of a weaving unit (12) for manufacture of a data storage device (2) according to one of claims 1 to 6.
